# EUROPEAN PATENT APPLICATION

(11) **EP 4 516 724 A1**
(43) Date of publication of application: **05.03.2025**
(21) Application number: 24179202.7
(22) Date of filing: 31.05.2024
(51) Int. Cl.: B81B 3/00, G01P 15/097, G01P 15/125, G01C 19/5684

(54) **SENSOR, SENSOR SYSTEM, AND ELECTRONIC DEVICE**

(30) Priority: 29.08.2023 JP 2023139069
(71) Applicant: Kabushiki Kaisha Toshiba, Tokyo 105-0023 (JP)
(72) Inventor: MURASE, Hideaki, Tokyo, 105-0023 (JP); TOMIZAWA, Yasushi, Tokyo, 105-0023 (JP); ONO, Daiki, Tokyo, 105-0023 (JP); MIYAZAKI, Fumito, Tokyo, 105-0023 (JP); UCHIDA, Kengo, Tokyo, 105-0023 (JP); MASUNISHI, Kei, Tokyo, 105-0023 (JP)
(74) Representative: Hoffmann Eitle

(57) **Abstract**

According to one embodiment, a sensor includes a base including a first face, a fixed portion fixed to the first face, and a movable portion supported by the fixed portion. The movable portion includes a plurality of annular portions, a plurality of connect portions, and a first structure. Each of the plurality of annular portions is provided around the fixed portion with the fixed portion as a center in a first plane along the first face. One of the plurality of connect portions connects two of the plurality of annular portions to each other. The plurality of annular portions include a first annular portion. The first annular portion is outermost of the plurality of annular portions. The first structure is connected to the first annular portion. The first annular portion is provided between the fixed portion and the first structure.

## Description

### FIELD

Embodiments described herein relate generally to a sensor, a sensor system, and an electronic device.

### BACKGROUND

For example, there are sensors having a MEMS (Micro Electro Mechanical Systems) structure. In some cases, electronic devices and the like are controlled based on information obtained by sensors. It is desired to improve the characteristics of sensors.

### BRIEF DESCRIPTION OF THE DRAWINGS

FIG. 1 is a schematic plan view illustrating a sensor according to a first embodiment;
FIG. 2 is a schematic cross-sectional view illustrating the sensor according to the first embodiment;
FIG. 3 is a schematic cross-sectional view illustrating the sensor according to the first embodiment;
FIG. 4 is a schematic plan view illustrating a part of the sensor according to the first embodiment;
FIG. 5 is a schematic plan view illustrating a sensor according to the first embodiment;
FIG. 6 is a schematic plan view illustrating a part of the sensor according to the first embodiment;
FIG. 7 is a schematic plan view illustrating a sensor according to the first embodiment;
FIG. 8 is a schematic diagram illustrating an electronic device according to a second embodiment;
FIGS. 9A to 9H are schematic views illustrating applications of the electronic device according to the embodiment; and
FIGS. 10A and 10B are schematic views illustrating applications of the sensor according to the embodiment.

### DETAILED DESCRIPTION

According to one embodiment, a sensor includes a base including a first face, a fixed portion fixed to the first face, and a movable portion supported by the fixed portion. A first gap is provided between the first face and the movable portion. The movable portion includes a plurality of annular portions, a plurality of connect portions, and a first structure. Each of the plurality of annular portions is provided around the fixed portion with the fixed portion as a center in a first plane along the first face. The plurality of connect portions extend along a radial direction. The radial direction passes through a first center of the fixed portion in the first plane and is along the first plane. One of the plurality of connect portions connects two of the plurality of annular portions to each other. The plurality of annular portions include a first annular portion. The first annular portion is outermost of the plurality of annular portions. The first structure is connected to the first annular portion. The first annular portion is provided between the fixed portion and the first structure. A first structure length of the first structure in the radial direction is longer than a first annular portion length of the first annular portion in the radial direction.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### (First Embodiment)

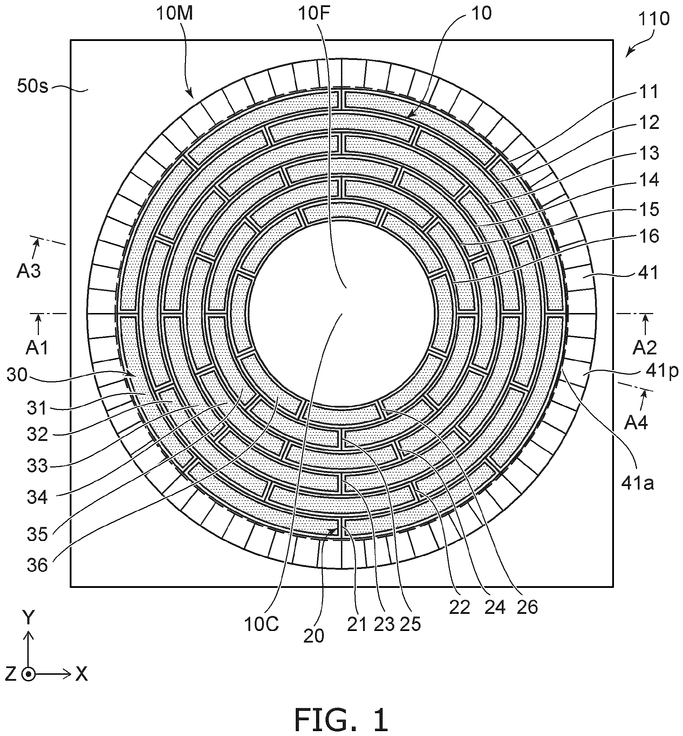

FIG. 1 is a schematic plan view illustrating a sensor according to a first embodiment.

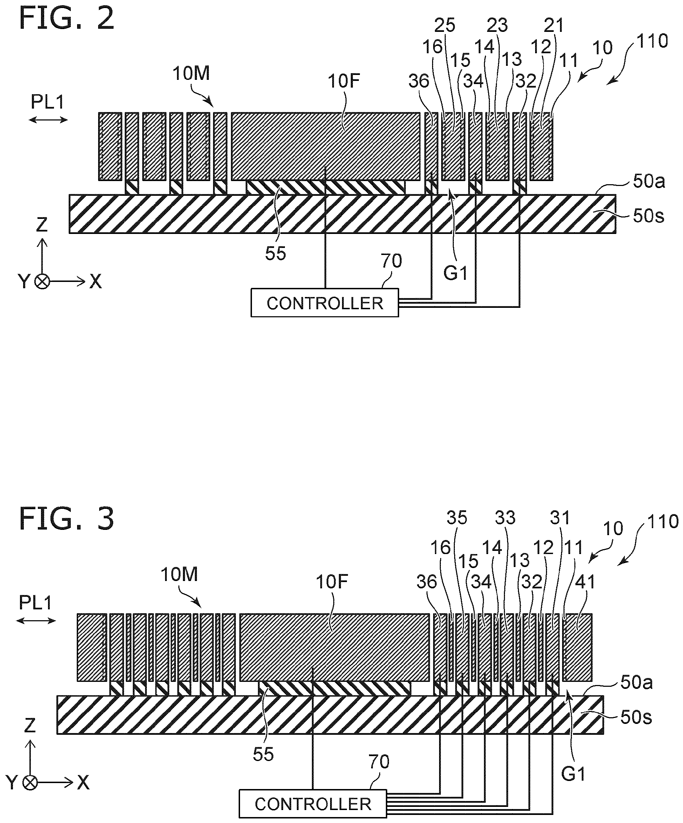

FIGS. 2 and 3 are schematic cross-sectional views illustrating the sensor according to the first embodiment.

FIG. 2 is a sectional view taken along the line A1-A2 in FIG. 1. FIG. 3 is a sectional view taken along the line A3-A4 in FIG. 1.

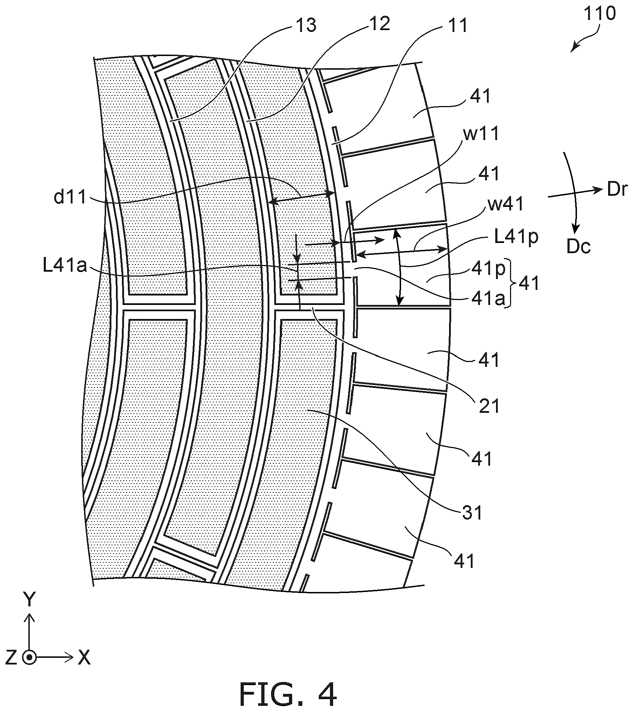

FIG. 4 is a schematic plan view illustrating a part of the sensor according to the first embodiment.

In FIG. 4, a part of FIG. 1 is shown enlarged.

As shown in FIGS. 1 to 3, a sensor 110 according to the embodiment includes a base 50s, a fixed portion 10F, and a movable portion 10M.

The base 50s includes a first face 50a. The fixed portion 10F is fixed to the first face 50a. The movable portion 10M is supported by the fixed portion 10F.

As shown in FIGS. 2 and 3, a first gap G1 is provided between the first face 50a and the movable portion 10M. For example, an insulating member 55 is provided on the first face 50a. The fixed portion 10F is provided on the insulating member 55. The insulating member 55 is not provided between the first face 50a and the movable portion 10M.

The movable portion 10M is electrically conductive. The movable portion 10M may include, for example, conductive silicon. The fixed portion 10F is electrically conductive. The fixed portion 10F may include, for example, conductive silicon. The fixed portion 10F is electrically connected to the movable portion 10M. The insulating member 55 may include, for example, silicon oxide.

The movable portion 10M includes a plurality of annular portions 10, a plurality of connect portions 20, and a first structure 41. Each of the plurality of annular portions 10 is provided around the fixed portion 10F with the fixed portion 10F as a center on the first plane PL1 along the first face 50a.

A direction perpendicular to the first plane PL1 is defined as a Z-axis direction. One direction perpendicular to the Z-axis direction is defined as an X-axis direction. A direction perpendicular to the Z-axis direction and the X-axis direction is defined as a Y-axis direction. The first plane PL1 is parallel to the X-Y plane.

For example, each of the plurality of annular portions 10 is concentric with the fixed portion 10F as the center. Each of the plurality of annular portions 10 extends along a circular circumferential direction Dc.

For example, the plurality of annular portions 10 include a first annular portion 11. The first annular portion 11 is the outermost of the plurality of annular portions 10. The plurality of annular portions 10 may include a second annular portion 12, a third annular portion 13, a fourth annular portion 14, a fifth annular portion 15, a sixth annular portion 16, and the like. The number of the plurality of annular portions 10 is arbitrary.

For example, the second annular portion 12 is provided between the first annular portion 11 and the fixed portion 10F. The second annular portion 12 is next to the first annular portion 11. The second annular portion 12 is closest to the first annular portion 11 among the plurality of annular portions 10.

The plurality of connect portions 20 extend along a radial direction Dr. The radial direction Dr passes through the first center 10C of the fixed portion 10F in the first plane PL1 and extends along the first plane PL1. One of the plurality of connect portions 20 connects two of the plurality of annular portions 10 to each other.

For example, the plurality of connect portions 20 include a first connect portion 21. The first connect portion 21 is provided between the second annular portion 12 and the first annular portion 11. The first connect portion 21 connects the second annular portion 12 and the first annular portion 11 to each other. The plurality of connect portions 20 may include a second connect portion 22, a third connect portion 23, a fourth connect portion 24, a fifth connect portion 25, a sixth connect portion 26, and the like. The number of the plurality of connect portions 20 is arbitrary.

The first structure 41 is connected to the first annular portion 11. The first annular portion 11 is provided between the fixed portion 10F and the first structure 41. The first structure 41 is provided outside the first annular portion 11.

FIG. 4 shows an enlarged example of a portion including the first structure 41. As shown in FIG. 4, a length of the first structure 41 in the radial direction Dr is defined as a first structure length w41. A length of the first annular portion 11 in the radial direction Dr is defined as a first annular portion length w11. The first structure length w41 is longer than the first annular portion length w11. For example, the first structure 41 functions as a mass member.

As shown in FIG. 1, a plurality of fixed electrodes 30 are provided in the sensor 110. For example, the plurality of fixed electrodes 30 are fixed to the first face 50a. For example, a signal including an alternating component is applied between a part of the plurality of fixed electrodes 30 and the movable portion 10M. Thereby, the movable portion 10M vibrates. When an external force is applied to the movable portion 10M vibrating, the vibration state changes. By detecting the change in the vibration state, the applied external force can be detected. The change in the vibration state is detected as a change in capacitance, for example. The change in the vibration state due to external forces are caused by, for example, Coriolis force. The change in the vibration state can be detected, for example, by another part of the plurality of fixed electrodes 30. The signal may be supplied by a controller 70, for example. For example, the controller 70 may detect the change in the vibration state.

In the embodiment, the first structure 41 is provided that functions as the mass member. By providing the first structure 41, for example, vibration of the movable portion 10M is stabilized. Vibration of a noise component is suppressed. Thereby, noise can be suppressed in the obtained signal. Highly accurate detection becomes possible.

In the embodiment, the first structure 41 is provided outside the first annular portion 11. The width of the first structure 41 (first structure length w41) can be increased. The mass of the first structure 41 can be increased. Thereby, a component that becomes unnecessary noise in the vibration of the movable portion 10M is suppressed. Thereby, higher precision detection can be performed.

For example, in a first reference example, a weight is provided between the first annular portion 11 and the second annular portion 12. In this case, the width of the weight cannot exceed the distance between the first annular portion 11 and the second annular portion 12. Therefore, in the first reference example, it is difficult to increase the mass of the weight.

In contrast, in the embodiment, the first structure 41 functioning as a mass member is provided outside the first annular portion 11. It is easy to increase the width of the first structure 41 (first structure length w41). The mass of the first structure 41 can be increased. Thereby, higher precision detection can be performed. According to the embodiment, it is possible to provide a sensor whose characteristics can be improved.

As already explained, in the sensor 110, the plurality of annular portions 10 may include the second annular portion 12. The second annular portion 12 is provided between the fixed portion 10F and the first annular portion 11. The second annular portion 12 is closest to the first annular portion 11 among the plurality of annular portions 10. A distance between the second annular portion 12 and the first annular portion 11 in the radial direction Dr is defined as a first distance d11 (see FIG. 4). The first distance d11 corresponds to, for example, the distance between the plurality of annular portions 10. The first distance d11 may substantially correspond to the pitch of the plurality of annular portions 10, for example.

In the embodiment, for example, the first structure length w41 is longer than the first distance d11. Thus, in the sensor 110, the first structure length w41 can be made longer than the pitch. Large mass can be obtained.

As shown in FIG. 4, the first structure 41 may include a first structure component 41p and a first structure connect portion 41a. The first structure connect portion 41a is provided between the first annular portion 11 and the first structure component 41p. The first structure connect portion 41a connects the first structure component 41p to the first annular portion 11. A length of the first structure connect portion 41a in the circumferential direction Dc centered on the fixed portion 10F along the first face 50a is defined as a first structure connect portion length L41a. A length of the first structure component 41p in the circumferential direction Dc is defined as a first structure component length L41p. The first structure connect portion length L41a is shorter than the first structure component length L41p.

The first structure component length L41p is connected to the first annular portion 11 by the first structure connect portion 41a being narrow. By such a structure, a high degree of freedom can be obtained in the movement of the first structure component 41p. For example, in the first annular portion 11, the uniformity of vibration characteristics can be improved. Noise can be further suppressed. Detection with higher accuracy becomes possible.

As shown in FIG. 1, the movable portion 10M may include a plurality of first structures 41. The plurality of first structures 41 are provided around the first annular portion 11 on the first plane PL1. The plurality of first structures 41 are arranged along the circumferential direction Dc. The circumferential direction Dc is a direction along the circumference around the fixed portion 10F along the first plane PL1.

As shown in FIG. 1, the plurality of fixed electrodes 30 are provided in the sensor 110. In this example, the plurality of fixed electrodes 30 include, for example, a first fixed electrode 31, a second fixed electrode 32, a third fixed electrode 33, a fourth fixed electrode 34, a fifth fixed electrode 35, and a sixth fixed electrode 36. The first fixed electrode 31 is provided between the first annular portion 11 and the second annular portion 12. The second fixed electrode 32 is provided between the second annular portion 12 and the third annular portion 13. The third fixed electrode 33 is provided between the third annular portion 13 and the fourth annular portion 14. The fourth fixed electrode 34 is provided between the fourth annular portion 14 and the fifth annular portion 15. The fifth fixed electrode 35 is provided between the fifth annular portion 15 and the sixth annular portion 16. The sixth fixed electrode 36 is provided between the sixth annular portion 16 and the fixed portion 10F.

In this example, a plurality of first fixed electrodes 31 are provided. The plurality of first fixed electrodes 31 are fixed to the first face 50a. The plurality of first fixed electrodes 31 are provided between the second annular portion 12 and the first annular portion 11. The plurality of first fixed electrodes 31 are arranged along the circumferential direction Dc. In this example, the number of the plurality of first fixed electrodes 31 (first fixed electrode number) is eight. For example, it is possible to generate vibrations along each of two crossing directions parallel to the first plane PL1 and to detect the vibrations. Furthermore, by correcting the resonant frequency of the vibration, more accurate detection can be performed.

The number of the plurality of first structures 41 (first structure number) is larger than the number of the plurality of first fixed electrodes 31 (first fixed electrode number). It is preferable that the first structure number is, for example, an integral multiple of two or more than the first fixed electrode number. The first structure number may be, for example, four times the first fixed electrode number. For example, high symmetry can be obtained in the movable portion 10M. More stable vibration can be obtained. In the embodiment, the first fixed electrode number may be eight or more.

Thus, the sensor 110 includes the base 50s including the first face 50a, the fixed portion 10F fixed to the first face 50a, and the movable portion 10M supported by the fixed portion 10F. The first gap G1 is provided between the first face 50a and the movable portion 10M. The movable portion 10M includes the plurality of annular portions 10, the plurality of connect portions 20, and the plurality of first structures 41. Each of the plurality of annular portions 10 is provided around the fixed portion 10F with the fixed portion 10F as the center on the first plane PL1 along the first face 50a. The plurality of connect portions 20 extend along the radial direction Dr. The radial direction Dr passes through the first center 10C of the fixed portion 10F in the first plane PL1 and extends along the first plane PL1. One of the plurality of connect portions 20 connects two of the plurality of annular portions 10 to each other. The plurality of annular portions 10 include the first annular portion 11. The first annular portion 11 is the outermost of the plurality of annular portions 10. The plurality of first structures 41 are connected to the first annular portion 11. The first annular portion 11 is provided between the fixed portion 10F and the plurality of first structures 41.

In the embodiment, the plurality of first structures 41 and the first annular portion 11 may satisfy at least one of a first condition, a second condition, or a third condition. In the first condition, a sum (first sum) of the areas in the first plane PL1 of each of the plurality of first structures 41 is larger than an area (first annular portion area) in the first plane PL1 of the first annular portion 11. In the second condition, a sum (second sum) of the volumes of each of the plurality of first structures 41 is larger than a volume (first annular portion volume) of the first annular portion 11. In the third condition, a sum (third sum) of the masses of each of the plurality of first structures 41 is larger than a mass (first annular portion mass) of the first annular portion 11.

The plurality of first structures 41 that satisfy such conditions function as a mass member. Such the plurality of first structures 41 are provided outside the first annular portion 11. The mass of the plurality of first structures 41 can be increased. Noise is suppressed and highly accurate detection is possible.

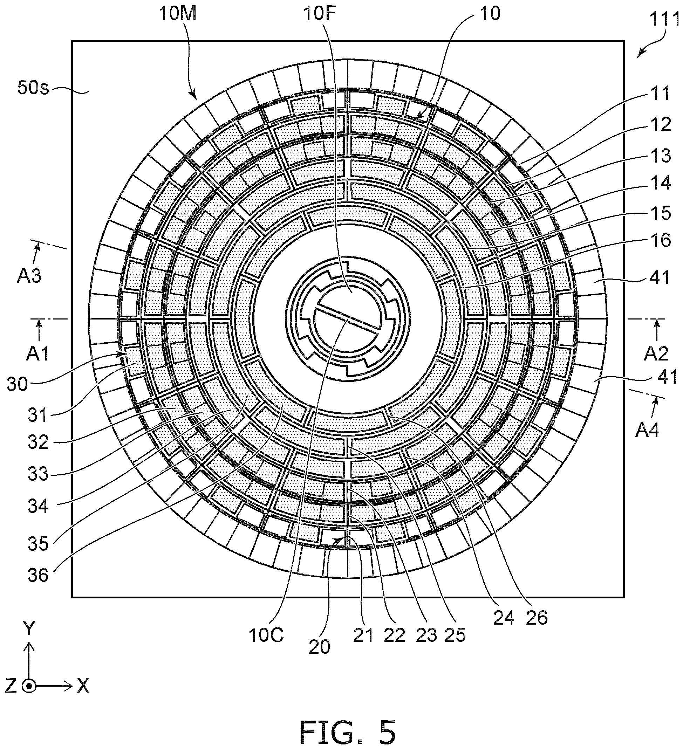

FIG. 5 is a schematic plan view illustrating a sensor according to the first embodiment.

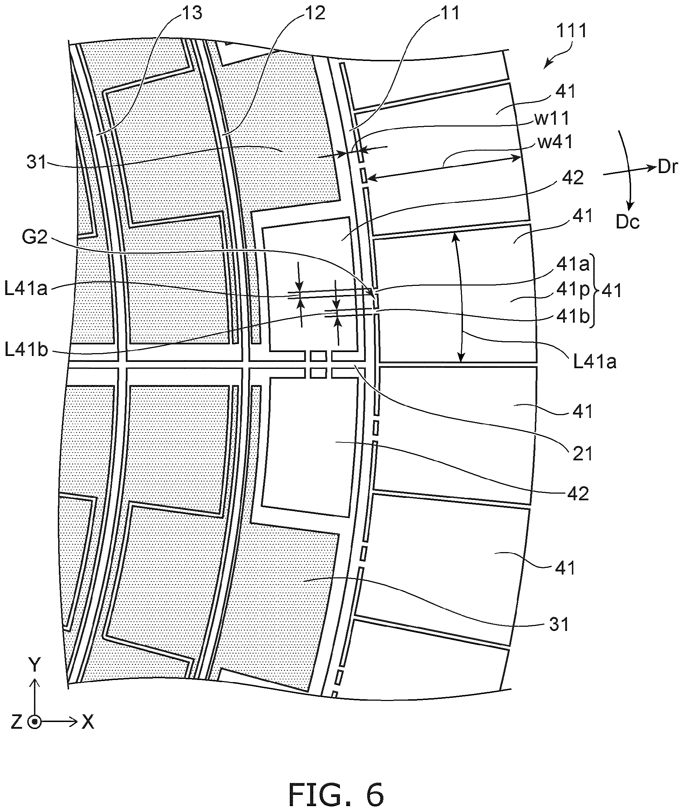

FIG. 6 is a schematic plan view illustrating a part of the sensor according to the first embodiment.

As shown in FIGS. 5 and 6, in a sensor 111 according to the embodiment, the first structure 41 is connected to the first annular portion 11 by a plurality of structure connect portions. The configuration of the sensor 111 except for this may be the same as the configuration of the sensor 110.

As shown in FIG. 6, the first structure 41 includes a first structure component 41p, a first structure connect portion 41a, and a second structure connect portion 41b. The first structure connect portion 41a is provided between the first annular portion 11 and the first structure component 41p, and connects the first structure component 41p to the first annular portion 11. The second structure connect portion 41b is provided between the first annular portion 11 and the first structure component 41p, and connects the first structure component 41p to the first annular portion 11. A direction from the first structure connect portion 41a to the second structure connect portion 41b is along the circumferential direction Dc.

A first structure connect portion length L41a of the first structure connect portion 41a in the circumferential direction Dc is shorter than a first structure component length L41p of the first structure component 41p in the circumferential direction Dc. A second structure connect portion length L41b of the second structure connect portion 41b in the circumferential direction Dc is shorter than the first structure component length L41p.

A second gap G2 is provided between the first structure connect portion 41a and the second structure connect portion 41b. For example, stable mechanical strength can be obtained by providing a plurality of structure connect portions. By providing the second gap G2 between the plurality of structure connect portions, processing through the second gap G2 becomes easier. High accuracy can be obtained in the movable portion 10M. Detection with higher accuracy becomes possible.

As shown in FIGS. 5 and 6, the sensor 111 may also further include the first fixed electrode 31. The first fixed electrode 31 is fixed to the first face 50a (see FIG. 3). The plurality of annular portions 10 may include the second annular portion 12. The second annular portion 12 is provided between the fixed portion 10F and the first annular portion 11. The second annular portion 12 is closest to the first annular portion 11 among the plurality of annular portions 10. The first fixed electrode 31 is provided between the second annular portion 12 and the first annular portion 11. In the sensor 111, the controller 70 (see FIGS. 2 and 3) may be provided. The controller 70 is configured to apply the electric signal between the fixed portion 10F and the first fixed electrode 31.

As shown in FIG. 6, the plurality of connect portions 20 include a first connect portion 21. The first connect portion 21 is provided between the second annular portion 12 and the first annular portion 11. The first connect portion 21 connects the second annular portion 12 and the first annular portion 11 to each other. The first connect portion 21 extends along the radial direction Dr.

As shown in FIG. 6, the movable portion 10M may further include the second structure 42. The second structure 42 is provided between the second annular portion 12 and the first annular portion 11. The second structure 42 is connected to the first connect portion 21. A direction from the first fixed electrode 31 to the second structure 42 is along the circumferential direction Dc.

The second structure 42 functions as a mass member, for example. Noise is further suppressed. Detection with higher accuracy becomes possible.

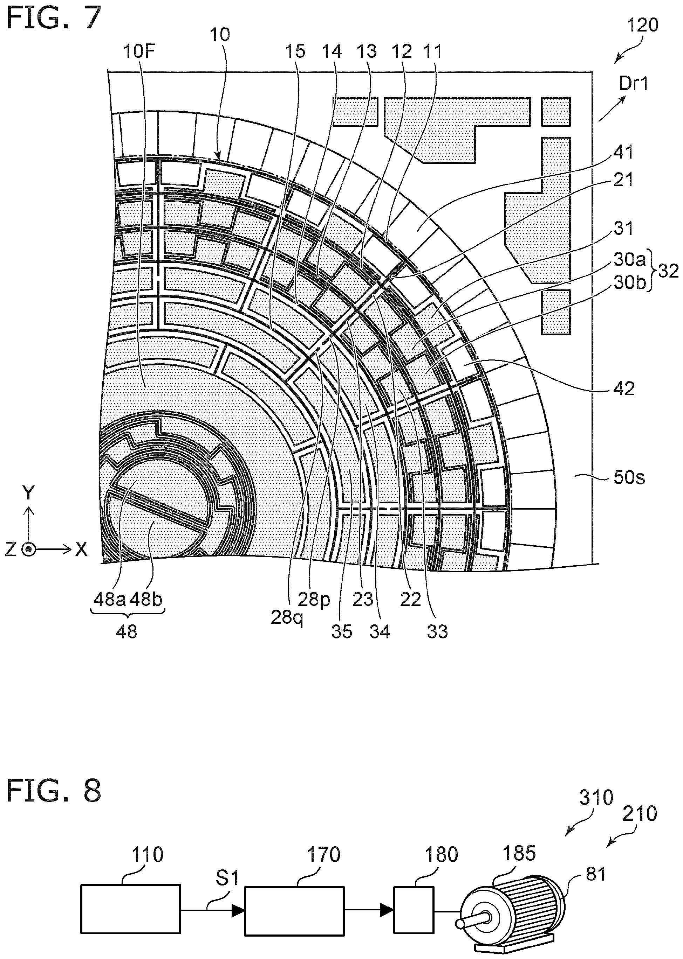

FIG. 7 is a schematic plan view illustrating a sensor according to the first embodiment.

FIG. 7 illustrates the fixed portion 10F and the movable portion 10M. In a sensor 120 according to the embodiment, at least one of the plurality of fixed electrodes 30 includes a plurality of partial electrodes. The configuration of the sensor 120 except for this may be the same as the configuration of the sensor 110 and the like.

In this example, at least one of the plurality of fixed electrodes 30 is the second fixed electrode 32. The second fixed electrode 32 includes a plurality of partial electrodes. The plurality of partial electrodes include a first partial electrode 30a and a second partial electrode 30b. The first partial electrode 30a and the second partial electrode 30b are arranged in the circumferential direction Dc. In this example, two of the second partial electrode 30b are provided. The first partial electrode 30a is provided between two partial electrodes in the circumferential direction Dc. Different signals may be supplied to the plurality of partial electrodes. A signal obtained from the plurality of partial electrodes may be processed to perform detection.

As shown in FIG. 7, the movable portion 10M may further include a first radial structure 28p. The first radial structure 28p is connected to one of the plurality of annular portions 10. In this example, the first radial structure 28p is connected to the fourth annular portion 14. The first radial structure 28p extends from the one of the plurality of annular portions 10 along a first radial direction Dr1. The first radial structure 28p is separated from another one of the plurality of annular portions 10 in the first radial direction Dr1. In this example, the first radial structure 28p is separated from the fifth annular portion 15 in the first radial direction Dr1. The other one of the plurality of annular portions 10 is next to the one of the plurality of annular portions 10 among the plurality of annular portions 10. The other one of the plurality of annular portions 10 is closest to the one of the plurality of annular portions 10 among the plurality of annular portions 10.

The movable portion 10M may further include a second radial structure 28q. The second radial structure 28q is connected to the other one of the plurality of annular portions 10. The second radial structure 28q is connected to the fifth annular portion 15. The second radial structure 28q extends from the other one of the plurality of annular portions 10 toward the one of the plurality of annular portions 10 along the first radial direction Dr1. The second radial structure 28q extends from the fifth annular portion 15 toward the fourth annular portion 14 along the first radial direction Dr1. The second radial structure 28q is separated from the first radial structure 28p in the first radial direction Dr1.

By providing such a radial structure, the overall mass distribution can be made uniform without connecting adjacent annular portions. It becomes easier to obtain higher characteristics.

As shown in FIG. 7, in this example, a direction in which the second connect portion 22 extends (first radial direction Dr1) is along a direction in which the third connect portion 23 extends. For example, it becomes easier to obtain a detection signal with high intensity.

As shown in FIG. 7, the sensor 120 may include a connect member 48. The connect member 48 is fixed to the first face 50a. The fixed portion 10F is provided around the connect member 48. Electrical connections may be made via the connect member 48. In this example, the connect member 48 includes a first connect member 48a and a second connect member 48b. The connect member 48 (for example, the first connect member 48a and the second connect member 48b) may be electrically insulated from the fixed portion 10F and the movable portion 10M. At least a part of the connect member 48 (for example, the first connect member 48a and the second connect member 48b, etc.) may be electrically connected to the fixed portion 10F or the movable portion 10M by wiring for electrical connection.

### (Second Embodiment)

A second embodiment relates to an electronic device.

FIG. 8 is a schematic diagram illustrating an electronic device according to a second embodiment.

As shown in FIG. 8, an electronic device 310 according to the embodiment includes the sensors according to the first to third embodiments and the circuit processor 170. In the example of FIG. 8, the sensor 110 is drawn as the sensor. The circuit processor 170 is configured to control a circuit 180 based on the signal S1 obtained from the sensor. The circuit 180 is, for example, a control circuit for a drive device 185. According to the embodiment, for example, the circuit 180 for controlling the drive device 185 can be controlled with high accuracy.

As shown in FIG. 8, the sensor system 210 according to the embodiment includes the sensor (for example, the sensor 110) according to the first embodiment and a detection target member 81. The sensor 110 is fixed to the detection target member 81. The sensor 110 can detect a signal from the detection target member 81.

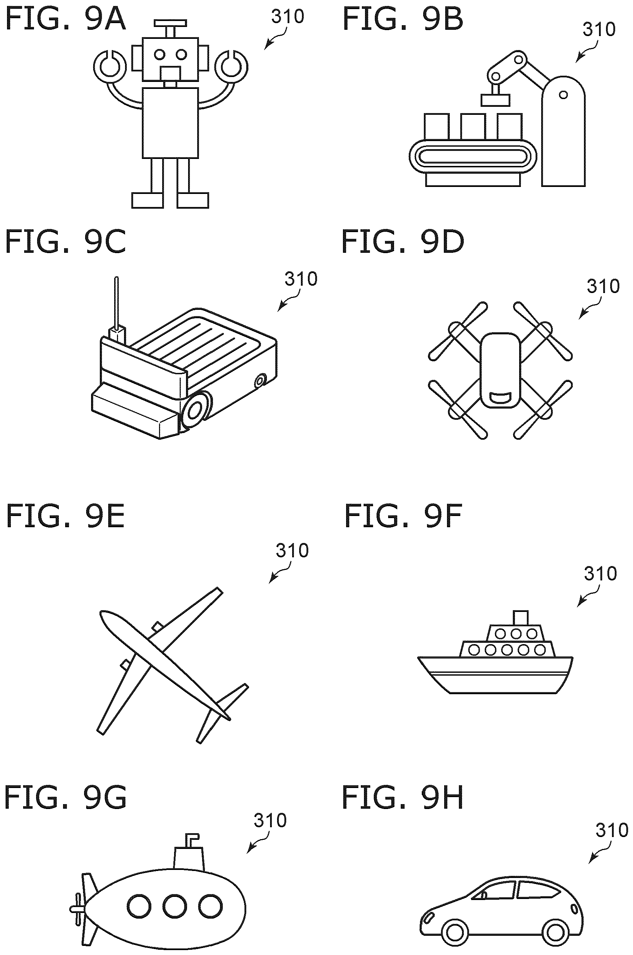

FIGS. 9A to 9H are schematic views illustrating applications of the electronic device according to the embodiment.

As shown in FIG. 9A, the electronic device 310 may be at least a portion of a robot. As shown in FIG. 9B, the electronic device 310 may be at least a portion of a machining robot provided in a manufacturing plant, etc. As shown in FIG. 9C, the electronic device 310 may be at least a portion of an automatic guided vehicle inside a plant, etc. As shown in FIG. 9D, the electronic device 310 may be at least a portion of a drone (an unmanned aircraft). As shown in FIG. 9E, the electronic device 310 may be at least a portion of an airplane. As shown in FIG. 9F, the electronic device 310 may be at least a portion of a ship. As shown in FIG. 9G, the electronic device 310 may be at least a portion of a submarine. As shown in FIG. 9H, the electronic device 310 may be at least a portion of an automobile. The electronic device 310 may include, for example, at least one of a robot or a moving body.

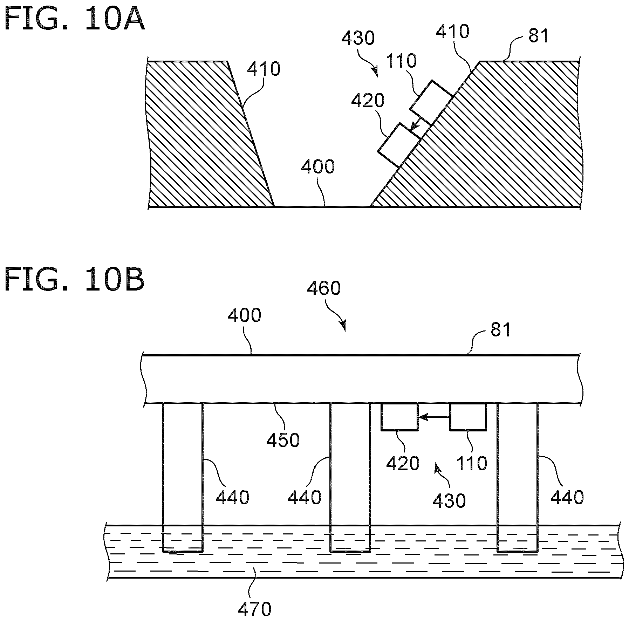

FIGS. 10A and 10B are schematic views illustrating applications of the sensor according to the embodiment.

As shown in FIG. 10A, a sensor 430 according to the fifth embodiment includes the sensor according to one of the first to third embodiments, and a transmission/reception part 420. In the example of FIG. 10A, the sensor 110 is illustrated as the sensor. The transmission/reception part 420 is configured to transmit the signal obtained from the sensor 110 by, for example, at least one of wireless and wired methods. The sensor 430 is provided on, for example, a slope surface 410 such as a road 400. The sensor 430 can monitor the state of, for example, a facility (e.g., infrastructure). The sensor 430 may be, for example, a state monitoring device.

For example, the sensor 430 detects a change in the state of a slope surface 410 of a road 400 with high accuracy. The change in the state of the slope surface 410 includes, for example, at least one of a change in the inclination angle and a change in the vibration state. The signal (inspection result) obtained from the sensor 110 is transmitted by the transmission/reception part 420. The status of a facility (e.g., infrastructure) can be monitored, for example, continuously.

As shown in FIG. 10B, the sensor 430 is provided, for example, in a portion of a bridge 460. The bridge 460 is provided above the river 470. For example, the bridge 460 includes at least one of a main girder 450 and a pier 440. The sensor 430 is provided on at least one of the main girder 450 and the pier 440. For example, at least one of the angles of the main girder 450 and the pier 440 may change due to deterioration or the like. For example, the vibration state may change in at least one of the main girder 450 and the pier 440. The sensor 430 detects these changes with high accuracy. The detection result can be transmitted to an arbitrary place by the transmission/reception part 420. Abnormalities can be detected effectively.

The embodiments may include the following Technical proposals:
(Technical proposal 1) A sensor, comprising:
   a base including a first face;
   a fixed portion fixed to the first face; and
   a movable portion supported by the fixed portion,
   a first gap being provided between the first face and the movable portion,
   the movable portion including a plurality of annular portions, a plurality of connect portions, and a first structure,
   each of the plurality of annular portions being provided around the fixed portion with the fixed portion as a center in a first plane along the first face,
   the plurality of connect portions extending along a radial direction,
   the radial direction passing through the first center of the fixed portion in the first plane and being along the first plane,
   one of the plurality of connect portions connecting two of the plurality of annular portions to each other,
   the plurality of annular portions including a first annular portion,
   the first annular portion being outermost of the plurality of annular portions,
   the first structure being connected to the first annular portion,
   the first annular portion being provided between the fixed portion and the first structure, and
   a first structure length of the first structure in the radial direction being longer than a first annular portion length of the first annular portion in the radial direction.
(Technical proposal 2) The sensor according to Technical proposal 1, wherein
   the plurality of annular portions include a second annular portion,
   the second annular portion is provided between the fixed portion and the first annular portion,
   the second annular portion is closest to the first annular portion among the plurality of annular portions, and
   the first structure length is longer than a first distance in the radial direction between the second annular portion and the first annular portion.
(Technical proposal 3) The sensor according to Technical proposal 1 or 2, wherein
   the first structure includes a first structure component and a first structure connect portion,
   the first structure connect portion is provided between the first annular portion and the first structure component, and connects the first structure component to the first annular portion, and
   a first structure connect portion length of the first structure connect portion in a circumferential direction centered on the fixed portion along the first face is shorter than a first structure component length of the first structure component in the circumferential direction.
(Technical proposal 4) The sensor according to Technical proposal 3, wherein
   the first structure further includes a second structure connect portion,
   the second structure connect portion is provided between the first annular portion and the first structure component, and connects the first structure component to the first annular portion,
   a direction from the first structure connect portion to the second structure connect portion is along the circumferential direction, and
   a second structure connect portion length of the second structure connect portion in the circumferential direction is shorter than the first structure component length.
(Technical proposal 5) The sensor according to Technical proposal 2, further comprising:
   a first fixed electrode fixed to the first face, and
   the first fixed electrode being provided between the second annular portion and the first annular portion.
(Technical proposal 6) The sensor according to Technical proposal 5, further comprising:
   a controller configured to apply an electrical signal between the fixed portion and the first fixed electrode.
(Technical proposal 7) The sensor according to Technical proposal 2, wherein
   the movable potion includes a plurality of the first structures,
   the plurality of first structures are provided around the first annular portion in the first plane, and
   the plurality of first structures are arranged along a circumferential direction centered on the fixed portion in the first plane.
(Technical proposal 8) The sensor according to Technical proposal 7, further comprising:
   a plurality of first fixed electrodes fixed to the first face,
   the plurality of first fixed electrodes being provided between the second annular portion and the first annular portion,
   the plurality of first fixed electrodes being arranged along the circumferential direction, and
   a first structure number of the plurality of first structures being greater than a first fixed electrode number of the plurality of first fixed electrodes.
(Technical proposal 9) The sensor according to Technical proposal 8, wherein
   the first fixed electrode number is 8 or more.
(Technical proposal 10) The sensor according to Technical proposal 9, wherein
   the first structure number is an integral multiple of 2 or more of the first fixed electrode number.
(Technical proposal 11) A sensor, comprising:
   a base including a first face;
   a fixed portion fixed to the first face; and
   a movable portion supported by the fixed portion,
   a first gap being provided between the first face and the movable portion,
   the movable portion including a plurality of annular portions, a plurality of connect portions, and a plurality of first structures,
   each of the plurality of annular portions being provided around the fixed portion with the fixed portion as a center in a first plane along the first face,
   the plurality of connect portions extending along a radial direction,
   the radial direction passing through a first center of the fixed portion in the first plane and being along the first plane,
   one of the plurality of connect portions connecting two of the plurality of annular portion to each other,
   the plurality of annular portions including a first annular portion,
   the first annular portion being outermost of the plurality of annular portions,
   the plurality of first structures being connected to the first annular portion,
   the first annular portion being provided between the fixed portion and the plurality of first structures,
   the plurality of first structures and the first annular portion satisfying at least one of a first condition, a second condition, or a third condition,
   in the first condition, a first sum of areas of each of the plurality of first structures in the first plane being larger than a first annular portion area of the first annular portion in the first plane,
   in the second condition, a second sum of volumes of each of the plurality of first structures being larger than a first annular portion volume of the first annular portion, and
   in the third condition, a third sum of the masses of each of the plurality of first structures being greater than a first annular portion mass of the first annular portion.
(Technical proposal 12) The sensor according to Technical proposal 11, wherein
   the first structure includes a first structure component and a first structure connect portion,
   the first structure connect portion is provided between the first annular portion and the first structure component, and connects the first structure component to the first annular portion, and
   a first structure connect portion length of the first structure connect portion in a circumferential direction centered on the fixed portion along the first plane is shorter than a first structure component length of the first structure component in the circumferential direction.
(Technical proposal 13) The sensor according to Technical proposal 12, wherein
   the first structure further includes a second structure connect portion,
   the second structure connect portion is provided between the first annular portion and the first structure component, and connects the first structure component to the first annular portion,
   a direction from the first structure connect portion to the second structure connect portion is along the circumferential direction, and
   a second structure connect portion length of the second structure connection portion in the circumferential direction is shorter than the first structure component length.
(Technical proposal 14) The sensor according to Technical proposal 12 or 13, further comprising:
   a first fixed electrode fixed to the first face,
   the plurality of annular portions including a second annular portion,
   the second annular portion being provided between the fixed portion and the first annular portion,
   the second annular portion being closest to the first annular portion among the plurality of annular portion, and
   the first fixed electrode being provided between the second annular portion and the first annular portion.
(Technical proposal 15) The sensor according to Technical proposal 14, further comprising:
   a controller configured to apply an electrical signal between the fixed portion and the first fixed electrode.
(Technical proposal 16) The sensor according to Technical proposal 14 or 15, wherein
   the plurality of connect portion includes a first connect portion,
   the first connect portion is provided between the second annular portion and the first annular portion,
   the first connect portion connects the second annular portion and the first annular portion to each other,
   the movable portion further includes a second structure,
   the second structure is provided between the second annular portion and the first annular portion,
   the second structure is connected to the first connect portion, and
   a direction from the first fixed electrode to the second structure is along the circumferential direction.
(Technical proposal 17) A sensor, comprising:
   a base including a first face;
   a fixed portion fixed to the first face; and
   a movable portion supported by the fixed portion,
   a first gap being provided between the first face and the movable portion,
   the movable portion including a plurality of annular portions, a plurality of connect portions, and a plurality of first structures,
   each of the plurality of annular portions being provided around the fixed portion with the fixed portion as a center on a first plane along the first face,
   the plurality of connect portions extending along a radial direction,
   the radial direction passing through a first center of the fixed portion in the first plane and being along the first plane,
   one of the plurality of connect portions connecting two of the plurality of annular portions to each other,
   the plurality of annular portions including a first annular portion,
   the first structure being connected to the first annular portion,
   a first structure length of the first structure in the radial direction being longer than a first annular portion length of the first annular portion in the radial direction,
   the first structure including a first structure component, a first structure connect portion, and a second structure connect portion,
   the first structure connect portion being provided between the first annular portion and the first structure component, and connecting the first structure component to the first annular portion,
   the second structure connect portion being provided between the first annular portion and the first structure component, and connecting the first structure component to the first annular portion, and
   a direction from the first structure connect portion to the second structure connect portion being along a circumferential direction centered on the fixed portion along the first plane.
(Technical proposal 18) The sensor according to Technical proposal 17, wherein
   a first structure connect portion length of the first structure connect portion in the circumferential direction is shorter than a first structure component length of the first structure component in the circumferential direction, and
   a second structure connect portion length of the second structure connect portion in the circumferential direction is shorter than the first structure component length.
(Technical proposal 19) A sensor system, comprising:
   the sensor according to any one of Technical proposals 1-18; and
   a detection target member, the sensor being fixed to the detection target member.
(Technical proposal 20) An electronic device, comprising:
   the sensor according to any one of Technical proposals 1-18; and
   a circuit controller configured to control a circuit based on a signal obtained from the sensor.

According to the embodiment, a sensor, a sensor system, and an electronic device whose characteristics can be improved can be provided.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in the sensor such as members, substrates, sensor sections, housings, sensor elements, bases, fixed portions, movable portions, controllers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all sensors, all sensor systems, and all electronic devices practicable by an appropriate design modification by one skilled in the art based on the sensors, the sensor systems, and the electronic devices described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A sensor, comprising:
a base including a first face;
a fixed portion fixed to the first face; and
a movable portion supported by the fixed portion,
a first gap being provided between the first face and the movable portion,
the movable portion including a plurality of annular portions, a plurality of connect portions, and a first structure,
each of the plurality of annular portions being provided around the fixed portion with the fixed portion as a center in a first plane along the first face,
the plurality of connect portions extending along a radial direction,
the radial direction passing through a first center of the fixed portion in the first plane and being along the first plane,
one of the plurality of connect portions connecting two of the plurality of annular portions to each other,
the plurality of annular portions including a first annular portion,
the first annular portion being outermost of the plurality of annular portions,
the first structure being connected to the first annular portion,
the first annular portion being provided between the fixed portion and the first structure, and
a first structure length of the first structure in the radial direction being longer than a first annular portion length of the first annular portion in the radial direction.

2. The sensor according to claim 1, wherein
the plurality of annular portions include a second annular portion,
the second annular portion is provided between the fixed portion and the first annular portion,
the second annular portion is closest to the first annular portion among the plurality of annular portions, and
the first structure length is longer than a first distance in the radial direction between the second annular portion and the first annular portion.

3. The sensor according to claim 1 or 2, wherein
the first structure includes a first structure component and a first structure connect portion,
the first structure connect portion is provided between the first annular portion and the first structure component, and connects the first structure component to the first annular portion, and
a first structure connect portion length of the first structure connect portion in a circumferential direction centered on the fixed portion along the first face is shorter than a first structure component length of the first structure component in the circumferential direction.

4. The sensor according to claim 3, wherein
the first structure further includes a second structure connect portion,
the second structure connect portion is provided between the first annular portion and the first structure component, and connects the first structure component to the first annular portion,
a direction from the first structure connect portion to the second structure connect portion is along the circumferential direction, and
a second structure connect portion length of the second structure connect portion in the circumferential direction is shorter than the first structure component length.

5. The sensor according to claim 2, further comprising:
a first fixed electrode fixed to the first face, and
the first fixed electrode being provided between the second annular portion and the first annular portion.

6. The sensor according to claim 5, further comprising:
a controller configured to apply an electrical signal between the fixed portion and the first fixed electrode.

7. The sensor according to claim 2, wherein
the movable potion includes a plurality of the first structures,
the plurality of first structures are provided around the first annular portion in the first plane, and
the plurality of first structures are arranged along a circumferential direction centered on the fixed portion in the first plane.

8. The sensor according to claim 7, further comprising:
a plurality of first fixed electrodes fixed to the first face,
the plurality of first fixed electrodes being provided between the second annular portion and the first annular portion,
the plurality of first fixed electrodes being arranged along the circumferential direction, and
a first structure number of the plurality of first structures being greater than a first fixed electrode number of the plurality of first fixed electrodes.

9. The sensor according to claim 8, wherein
the first fixed electrode number is 8 or more.

10. The sensor according to claim 9, wherein
the first structure number is an integral multiple of 2 or more of the first fixed electrode number.

11. A sensor system, comprising:
the sensor according to any one of claims 1-10; and
a detection target member, the sensor being fixed to the detection target member.

12. An electronic device, comprising:
the sensor according to any one of claims 1-10; and
a circuit controller configured to control a circuit based on a signal obtained from the sensor.
